# EUROPEAN PATENT APPLICATION

(11) **EP 4 651 645 A1**
(43) Date of publication of application: **19.11.2025**
(21) Application number: 23916201.9
(22) Date of filing: 13.12.2023
(51) Int. Cl.: H05K 3/34, B23K 1/08, B23K 3/06, B23K 3/08

(54) **SOLDER PROCESS APPARATUS**

(30) Priority: 10.01.2023 JP 2023001667
(71) Applicant: Senju Metal Industry Co., Ltd., Tokyo 120-8555 (JP)
(72) Inventor: KAWASHIMA Yasuji, Ibaraki-shi, Osaka 567-0006 (JP); KAGAYA Tomotake, Tokyo 120-8555 (JP); TAGUCHI Hiroshi, Tokyo 120-8555 (JP); SHINOHARA Katsuhiro, Tokyo 120-8555 (JP)
(74) Representative: Hindles Limited
(86) International application number: PCT/JP2023/044563
(87) International publication number: WO 2024/150587

(57) **Abstract**

A solder process apparatus has a storage tank 110 that stores molten solder; and an extension part 210, wherein a part of the extension part 210 is extended in the molten solder in the storage tank 110, and the extension part 210 reciprocates in a horizontal direction in the molten solder while performing both upward movement and downward movement at least once when moving from one side to the other side in the horizontal direction.

## Description

### TECHNICAL FIELD

The present invention relates to a solder process apparatus that supplies molten solder to a substrate.

### BACKGROUND ART

Conventionally, jet soldering apparatuses for supplying molten solder to a substrate are known. In addition, it is also known that jet soldering apparatuses form dross due to oxidation of molten solder, and JP 2003-53529 A and JP 2002-80950 A propose apparatuses for dealing with such dross.

JP 2003-53529 A proposes an oxide separation device in which a large number of vanes are installed on a shaft, with flat surfaces of the vanes being orthogonal to a liquid surface of the molten solder, the shaft is located at a position where some of the vanes are submerged in molten solder, and the shaft is linked to a motor to be rotated.

JP 2002-80950 A proposes a jet solder bath in which a pan circulating, in one direction, molten solder jetted from a jet nozzle is installed on a side surface of the jet nozzle, a cover having an opening toward the nozzle is installed on an end part of the jet solder bath in an outflow direction of the molten solder, and a screw linked to a motor is installed in the cover.

### SUMMARY OF INVENTION

### PROBLEM TO BE SOLVED BY INVENTION

Also in the cases of employing JP 2003-53529 A and JP 2002-80950 A, the decomposition of the dross can be realized at a certain level, but effects thereof are limited.

The present invention provides a solder process apparatus capable of more effectively decomposing dross.

### MEANS FOR SOLVING PROBLEM

### [Concept 1]

A solder process apparatus according to the first aspect of the present invention may comprise:
a storage tank that stores molten solder; and
an extension part, wherein a part of the extension part is extended in the molten solder in the storage tank, and the extension part reciprocates in a horizontal direction in the molten solder while changing a position in a vertical direction.

### [Concept 2]

The solder process apparatus according to concept 1 may comprise:
a moving part that reciprocates the extension part in the horizontal direction in the molten solder;
a moving body that is moved in the horizontal direction by a driving force from the moving part; and
a wave-shaped guide part for guiding the moving body.

### [Concept 3]

In the solder process apparatus according to concept 2,
an elastic member that applies an elastic force downward or upward to the moving body may be provided.

### [Concept 4]

In the solder process apparatus according to concepts 1 to 3,
at least a part of a distal end side of the extension part may have a non-linear shape.

### [Concept 5]

In the solder process apparatus according to concept 4,
the extension part may have a twisted shape, an uneven shape, or a recess part or a protrusion part on a surface.

### [Concept 6]

The solder process apparatus according to any one of concepts 1 to 5 may comprise:
a supply unit that is provided in the storage tank, and provides the molten solder, and
a partition part that is partially immersed in the molten solder, and is provided between a movement region of the extension part and the supply unit.

### [Concept 7]

In the solder process apparatus according to any one of claims 1 to 6,
the extension part may have a first extension part provided on one side in the horizontal direction and a second extension part provided on the other side in the horizontal direction,
the first extension part may be provided at an end part of the moving main body on one side,
the second extension part may be provided at an end part of the moving main body on the other side,
each of the first extension part and the second extension part may include a plurality of extension members, and
the plurality of extension members may be provided parallel along a normal direction of reciprocal movement.

### [Concept 8]

A solder process apparatus according to the second aspect of the present invention may comprise:
a storage tank that stores molten solder;
a supply unit that is provided in the storage tank, and provides the molten solder;
an extension part, wherein a part of the extension part is extended in the molten solder in the storage tank, and the extension part reciprocates in a horizontal direction in the molten solder; and
a partition part that is partially immersed in the molten solder, and is provided between a movement region of the extension part and the supply unit.

### [Concept 9]

In the solder process apparatus according to concept 8,
the partition part may be detachably installed in the storage tank.

### [Concept 10]

In the solder process apparatus according to concept 8 or 9,
the partition part may have a partition main body extending in a moving direction of the extension part between the supply unit and the extension part, and a side partition part or a pair of side partition parts provided at both end parts of the partition main body and extending in a direction orthogonal to the moving direction of the extension part.

### [Concept 11]

In the solder process apparatus according to concept 10,
a height of the side partition part may be higher than a height of the partition main body.

### [Concept 12]

In the solder process apparatus according to any one of concepts 8 to 11,
the partition part may have a partition main body extending in a moving direction of the extension part between the supply unit and the extension part, and
a recess part may be provided in a region including a central portion of the partition main body.

### [Concept 13]

In the solder process apparatus according to any one of concepts 8 to 12,
a lower end of the partition part may be positioned 20 to 80 mm below a liquid surface of the molten solder.

### [Concept 14]

In the solder process apparatus according to any one of concepts 8 to 13,
a lower end of the partition part may be located at the same position as a lower end of the extension part or at a position lower than a lower end of the extension part, and at a position of 10 mm to 200 mm from a bottom surface of the storage tank.

### [Concept 15]

In the solder process apparatus according to any one of concepts 8 to 13,
the extension part may reciprocate in a horizontal direction in the molten solder while changing a position in a vertical direction, and
a lower end of the partition part may be located at the same position as an average position of a lower end of the extension part or at a position lower than an average position of a lower end of the extension part, and at a position of 10 mm to 200 mm from a bottom surface of the storage tank.

### EFFECT OF INVENTION

As one aspect of the present invention, in a case of employing an aspect in which an extension part reciprocates in a horizontal direction in molten solder while changing a position in a vertical direction, the decomposition of dross can be performed significantly more effectively. In addition, as another aspect of the present invention, in a case of employing an aspect in which an extension part reciprocating in a horizontal direction is provided in molten solder, and a partition part is provided between a movement region of the extension part and a supply unit, the partition part blocks movement of dross toward the supply unit, so that effects of decomposition by the extension part reciprocating in the horizontal direction can be enhanced.

### BRIEF DESCRIPTION OF FIGURES

[Fig. 1] Fig. 1 is a schematic diagram illustrating a soldering apparatus according to the present embodiment.
[Fig. 2] Fig. 2 is a side sectional view of a jet solder apparatus illustrating an aspect in which a first extension part and a second extension part are provided in the present embodiment.
[Fig. 3] Fig. 3 is a top plan view of the jet solder apparatus employing another aspect in which the first extension part is integrated with a first coupling body and a second extension part is integrated with a second coupling body in the present embodiment.
[Fig. 4] Fig. 4 is a top plan view of the jet solder apparatus employing still another aspect in which the first extension part is fastened to a moving main body by a fastening member and a second extension part is fastened to the moving main body by a fastening member in the present embodiment.
[Fig. 5A] Fig. 5A is a side view illustrating still another aspect in which a first extension member is integrated with the first coupling body and a second extension member is integrated with the second coupling body in the present embodiment.
[Fig. 5B] Fig. 5B is a top plan view illustrating still another aspect in which the first extension member is integrated with the first coupling body and the second extension member is integrated with the second coupling body in the present embodiment.
[Fig. 6A] Fig. 6A is a side view illustrating still another aspect in which the first extension member and the second extension member are fastened to the moving main body by fastening members, respectively, in the present embodiment.
[Fig. 6B] Fig. 6B is a top plan view illustrating still another aspect in which the first extension member is fastened to the moving main body by the fastening member, and the second extension member is fastened to the moving main body by the fastening member in the present embodiment.
[Fig. 7] Fig. 7 is a side view of an example of a moving part used in the present embodiment from a side opposite to a supply unit.
[Fig. 8] Fig. 8 is a side cross-sectional view of the jet solder apparatus illustrating still another aspect in which the extension part is provided at only one position in a substrate conveyance direction (in a left-right direction in Fig. 8) in the present embodiment.
[Fig. 9] Fig. 9 is a side sectional view of the jet solder apparatus illustrating still another aspect in which a third extension part is provided in addition to the first extension part and the second extension part in the present embodiment.
[Fig. 10] Fig. 10 is a top plan view illustrating still another aspect in which the first extension member, the second extension member, and a third extension member are fastened to the moving main body by fastening members, respectively, in the present embodiment.
[Fig. 11] Fig. 11 is a top plan view illustrating still another aspect in which the first extension member is fastened to the moving main body by the fastening member in the present embodiment.
[Fig. 12] Fig. 12 is a side view illustrating still another aspect in which an elastic member presses the moving main body downward in the present embodiment.
[Fig. 13] Fig. 13 is a view of a partition part that can be used in the present embodiment in a direction in which a partition main body is set as a front side.
[Fig. 14] Fig. 14 is a side cross-sectional view of a separation device illustrating still another aspect in which the extension part is provided in the separation device installed separately from the jet soldering device in the present embodiment.
[Fig. 15] Fig. 15 is a top plan view illustrating still another aspect in which the extension part reciprocates in a direction orthogonal to the substrate conveyance direction, that is, the aspect in which the extension part is provided on a side downstream of the supply unit in the substrate conveyance direction, in the present embodiment.
[Fig. 16] Fig. 16 is a top plan view illustrating still another aspect in which the extension part reciprocates in the direction orthogonal to the substrate conveyance direction, that is, the aspect in which the extension part is provided on a side upstream of the supply unit in the substrate conveyance direction, in the present embodiment.
[Fig. 17A] Fig. 17A is a view illustrating still another aspect in which the extension part has a twisted shape on a distal end side thereof.
[Fig. 17B] Fig. 17B is a view illustrating still another aspect in which the extension part has an uneven part on the distal end side thereof.

### EMBODIMENT FOR IMPLEMENTING INVENTION

### EMBODIMENT

### <<Configuration>>

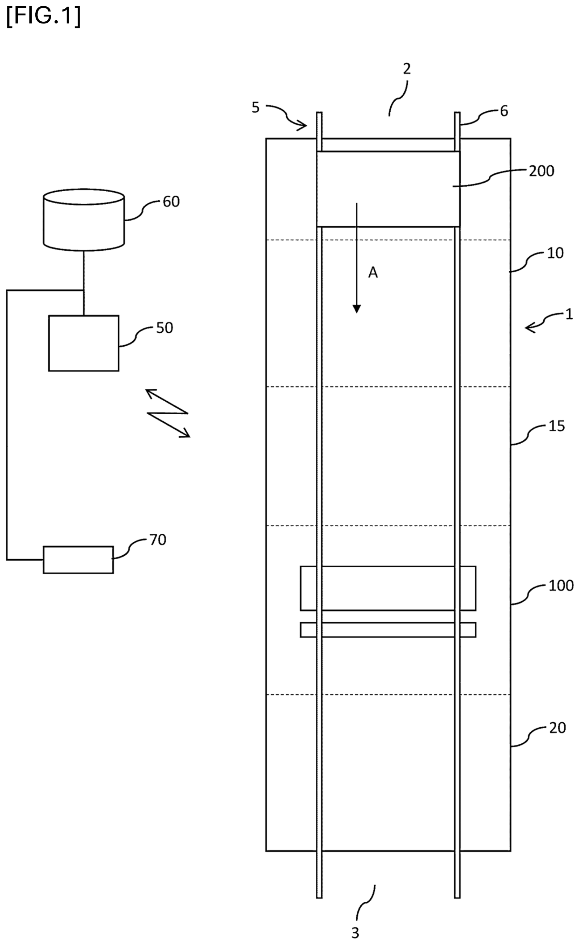

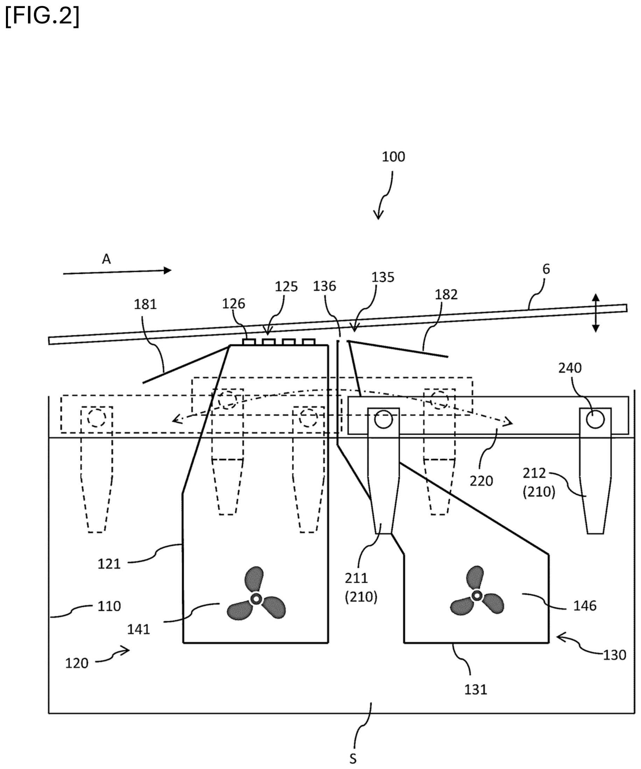

A soldering apparatus illustrated in Fig. 1 is an apparatus that performs soldering processing on a substrate 200 on which electronic components such as semiconductor elements, resistors, and capacitors are mounted on a circuit. Typically, the electronic components and the like are positioned on a lower side of the substrate 200. The soldering apparatus has a main body 1 and a conveyance unit 5 that conveys the substrate 200. The main body 1 has a carry-in port 2 through which the substrate 200 is carried in and a carry-out port 3 through which the substrate 200 is carried out. The substrate 200 may be conveyed at a predetermined angle, for example, an inclination of about 3 to 6 degrees when viewed from the side (see Fig. 2). In this case, a downstream side is positioned at a higher position than an upstream side in a substrate conveyance direction A. However, the present invention is not limited thereto, and the substrate 200 may be horizontally conveyed, for example. The conveyance unit 5 may have a conveyance driver (not illustrated) that applies a driving force to carry the substrate 200, and a conveyance rail 6 that guides the substrate 200.

As illustrated in Fig. 1, the main body 1 may be provided with a fluxer 10 for applying flux to the substrate 200, a preheater unit 15 for preheating the substrate 200 coated with flux, a jet soldering apparatus 100 for jetting molten solder into contact with the substrate 200, and a cooler 20 for cooling the soldered substrate 200. The substrate 200 conveyed along the conveyance rail 6 of the conveyance unit 5 sequentially passes through the fluxer 10, the preheater unit 15, the jet soldering apparatus 100, and the cooler 20. The jet soldering apparatus 100 may have a control unit 50 that gives a command to each component to control, a storage unit 60 that stores various pieces of information, and an operation unit 70 through which an operator operates the soldering apparatus by inputting various information. Note that in Fig. 1, the soldering apparatus is illustrated in an upper plan view except for the control unit 50, the storage unit 60, and an operation unit 70.

The fluxer 10 is used to apply flux to the conveyed substrate 200. The flux may include a solvent, an activator, and the like. The fluxer 10 may be provided with a plurality of coating apparatuses. The type of flux may be selectively used according to the type of solder and the type of the substrate 200.

The preheater unit 15 heats the substrate 200 to uniformly raise the substrate 200 to a predetermined temperature. When the substrate 200 is heated in this manner, the solder is easily attached to a predetermined part of the substrate 200. For example, a far-infrared panel heater is used as the preheater unit 15. The far-infrared panel heater can rapidly heat the substrate 200 to a set temperature. Furthermore. The substrate 200 may be heated by blowing gas (hot air) heated by the heater onto the substrate 200 by a fan. Furthermore, as the preheater unit 15, a halogen heater or the like may be used.

The cooler 20 has a cooling fan (not illustrated), and cools the substrate 200 soldered by the jet soldering apparatus 100. The control of the cooling fan may be only ON and OFF, but the wind speed may be adjusted. Furthermore, as the cooler 20, a chiller or the like may be used to cool the substrate 200 to a predetermined temperature.

The control unit 50 illustrated in Fig. 1 is communicably connected to the conveyance unit 5 including the conveyance rail 6, the fluxer 10, the preheater unit 15, the jet soldering apparatus 100, the cooler 20, the operation unit 70, and the storage unit 60. The communicable connections include both wired and wireless connections. The operation unit 70 may have a liquid crystal display panel, a numeric keypad, or the like, and is typically a personal computer, a smartphone, a tablet, or the like. When an operator operates the operation unit 70, the control unit 50 may control a conveyance speed by the conveyance unit 5, a timing of conveying the substrate 200, a temperature of the flux at the fluxer 10, an application amount of the flux, a temperature of the preheater unit 15, a temperature of molten solder S of the jet soldering apparatus 100, a jet amount, a jet speed, ON and OFF of the cooling fan of the cooler 20, and the like. The storage unit 60 may store information input by the operation unit 70, an instruction of the control unit 50, an operating time of the jet soldering apparatus 100, and the like.

Next, the jet soldering apparatus 100 of the present embodiment will be described. Typically, this jet soldering apparatus 100 corresponds to a solder process apparatus.

As illustrated in Fig. 2, the jet soldering apparatus 100 has a storage tank 110 that stores the molten solder S, a first pump 141 that is a first drive unit, a first supply port 125 that receives a driving force from the first pump 141 and jets the molten solder S, a second pump 146 that is a second drive unit, and a second supply port 135 that receives a driving force from the second pump 146 and jets the molten solder S. The molten solder S jetted from the first supply port 125 and the second supply port 135 is jetted upward from below. The molten solder S having received the driving force from the first pump 141 is pressure-fed in a duct and jetted toward the substrate 200 to attach the solder to a predetermined part of the substrate 200. Similarly, the molten solder S having received the driving force from the second pump 146 is pressure-fed in a duct and jetted toward the substrate 200 to attach the solder to a predetermined part of the substrate 200. The molten solder S is heated to a temperature of, for example, about 180°C to 250°C by a heater (not illustrated). The molten solder supplied from the first supply port 125 and the second supply port 135 may be circulated and used. In this case, it may be circulated through a filter (not illustrated). Each of the first pump 141 and the second pump 146 is typically constituted of one pump, but each of the first pump 141 and the second pump 146 may be constituted of a plurality of pumps.

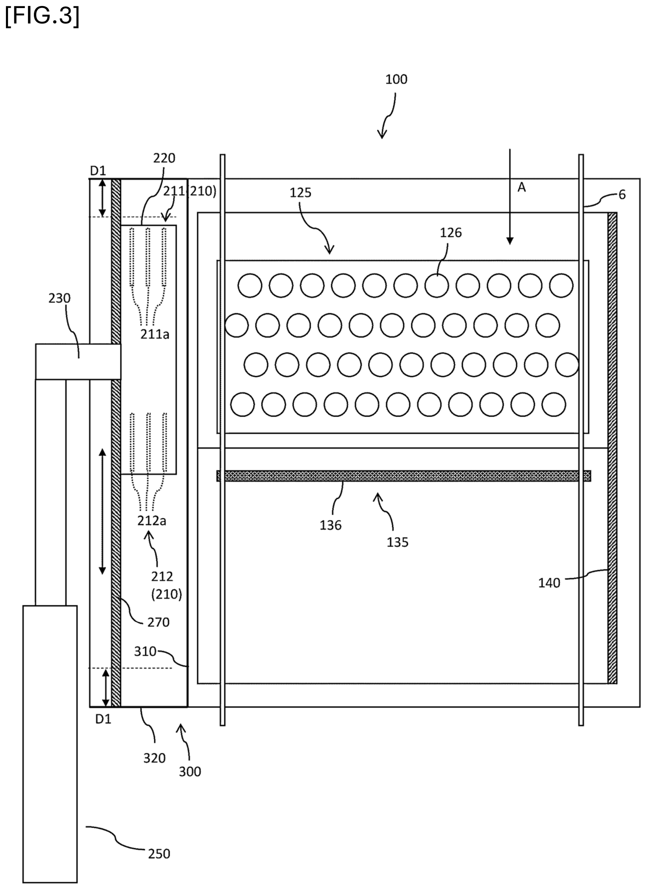

The first supply port 125 of the jet soldering apparatus 100 illustrated in Fig. 2 has a plurality of first openings 126 (see Fig. 3 etc.), and the first openings 126 constitute a primary jet nozzle. The plurality of first openings 126 are used to vigorously supply a large amount of molten solder S to the substrate 200. A second opening 136 of the second supply port 135 is a secondary jet nozzle, and is used to supply the molten solder S to the substrate 200 with weaker force than the first supply port 125. The jet solder supplied from the first supply port 125 is a dynamic supply for vigorously colliding the molten solder S against the substrate 200, and is a supply for spreading the molten solder S to every corner of the substrate 200. On the other hand, the jet solder supplied from the second supply port 135 is a static supply, and is a supply for cleanly attaching the solder to an electrode or the like of the substrate 200 by passing the jet solder through the molten solder S having a gentle flow.

In the present embodiment, a supply unit has a first supply unit 120 and a second supply unit 130. As illustrated in Fig. 2, a first supply unit 120 has a first housing 121 and the first supply port 125 provided on an upper surface of the first housing 121 and having one or the plurality of first openings 126 for supplying the molten solder S. The first opening 126 may be provided so as to protrude upward from the upper surface of the first housing 121. A second supply unit 130 has a second housing 131 and the second supply port 135 provided on an upper surface of the second housing 131 and having one or a plurality of the second openings 136 for supplying the molten solder S. The first housing 121 and the second housing 131 may be provided apart from each other, but they may be provided integrally. In a case where the first housing 121 and the second housing 131 are integrated, a part of the wall surface may be shared. In the present embodiment, the first supply port 125 may have the plurality of circular first openings 126 and the second supply port 135 may have one slit-shaped second opening 136 will be described as an example. However, the present invention is not limited to such an aspect, and for example, a plurality of the slit-shaped second openings 136 may be provided. In this case, the plurality of slit-shaped second openings 136 may be provided in an aspect of extending in parallel.

A temperature of the molten solder S is generally about 50°C higher than a melting temperature of the solder. In recent years, there has been an increasing need to lower a working temperature in order to reduce damage to components and reduce mechanical power consumption. Furthermore, since the market price of Sn and Ag has increased, it has been studied that a solder that does not use Sn or Ag is used, and typically, it has been studied that Sn-58Bi (melting point of 139°C) is used instead of Sn-3Ag-0.5Cu (melting point of 217°C). Sn-58Bi is a low-temperature eutectic solder. Note that, when Sn-58Bi is used, soldering can be performed at a temperature of 200°C or lower. On the other hand, although Sn-58Bi is inexpensive, Sn-58Bi has a property of being hard, brittle and easily oxidized, it is a material difficult to handle.

While the molten solder S is supplied, the molten solder S supplied from the first supply port 125 and the molten solder S supplied from the second supply port 135 are mixed. In this configuration, the molten solder S mixed in this manner may not be separated from the substrate 200 conveyed by the conveyance unit 5 between the first supply port 125 and the second supply port 135.

In the present embodiment, the molten solder S supplied from the first supply port 125 and the molten solder S supplied from the second supply port 135 are integrated and jetted to a position higher than a conveyance position of the substrate 200. However, the present invention is not limited to such an aspect and may employ an aspect in which a location where the molten solder S is not in contact with the substrate 200 is provided between the molten solder S supplied from the first supply port 125 and the molten solder S supplied from the second supply port 135, and the molten solder S is ejected in clearly two stages (see JP 2002-80950 A).

A total amount of the molten solder S per unit time supplied from the first openings 126 which are a primary jet nozzle may be about the same as a total amount of the molten solder S per unit time supplied from the second opening 136 which is a secondary jet nozzle, or may be 0.8 times or more and 1.2 times or less.

In a case where an aspect is employed in which the molten solder S supplied from the first supply port 125 and the molten solder S supplied from the second supply port 135 are integrated, the molten solder S supplied from the first openings 126 which are the primary jet nozzle may be ejected to a position higher than a surface of the molten solder S supplied from the second opening 136 which is the secondary jet nozzle. A height of the molten solder S to be ejected is, for example, about 10 mm from a distal end of the first opening 126. The molten solder S supplied from the second supply port 135 is pushed up by the molten solder S supplied from the first supply port 125.

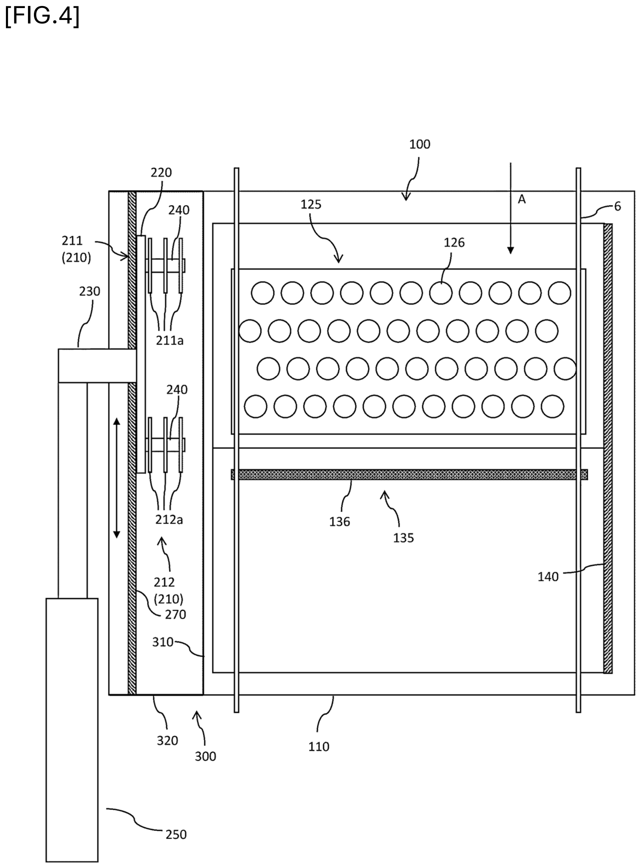

As illustrated in Fig. 2, an extension part 210 which is at least partially immersed in the molten solder S in the storage tank 110 and extends in the molten solder S, and a moving main body 220 on which the extension part 210 is mounted may be provided. In addition, a moving part 250 (see Figs. 3 and 4) may be provided to cause the moving main body 220 to reciprocate in a horizontal direction, thereby causing the extension part 210 to reciprocate in the horizontal direction in the molten solder S. As illustrated in Figs. 3 and 4, the moving part 250 and the moving main body 220 may be coupled to each other via a coupling body 230. A unit (assembly) including the extension part 210, the moving main body 220, the coupling body 230, and the moving part 250 may be provided. Such a unit may be retrofitted to an existing molten solder apparatus. The "reciprocating in the horizontal direction" in the present embodiment means reciprocating including a component in the horizontal direction and includes an aspect in which reciprocating is performed obliquely with respect to the horizontal direction. The "reciprocating in the horizontal direction" in the present embodiment may be reciprocating performed perfectly in the horizontal direction, or may include an aspect in which reciprocating is performed at an angle smaller than 45 degrees with respect to the horizontal direction. The extension part 210 may reciprocate in the horizontal direction in the molten solder S while performing both upward movement and downward movement at least once when moving from one side to the other side in the horizontal direction, and may reciprocate in the horizontal direction in the molten solder S while performing both the upward movement and the downward movement at least once when moving from the other side to the one side in the horizontal direction. At this time, the moving main body 220 may perform both upward movement and downward movement at least once when moving from the one side to the other side in the horizontal direction, and may perform both the upward movement and the downward movement at least once when moving from the other side to the one side in the horizontal direction.

The extension part 210 may reciprocate in the horizontal direction in the molten solder S while changing a position in a vertical direction. As confirmed by the inventors, by employing such an aspect, decomposition of dross, which is an oxide of solder, can be remarkably accelerated. Therefore, it is extremely advantageous to employ an aspect in which the extension part 210 reciprocates in the horizontal direction in the molten solder S while changing the position in the vertical direction. A change in the vertical direction is preferably 10 to 30 mm, and more preferably 15 to 25 mm. Since a length of the change in the vertical direction is determined by a moving speed of the extension part 210 in the horizontal direction, both the length of the change in the vertical direction and the moving speed in the horizontal direction may be adjusted, as appropriate. However, the present invention is not limited to such an aspect, and the extension part 210 may simply reciprocate in the horizontal direction in the molten solder S without changing the position in the vertical direction.

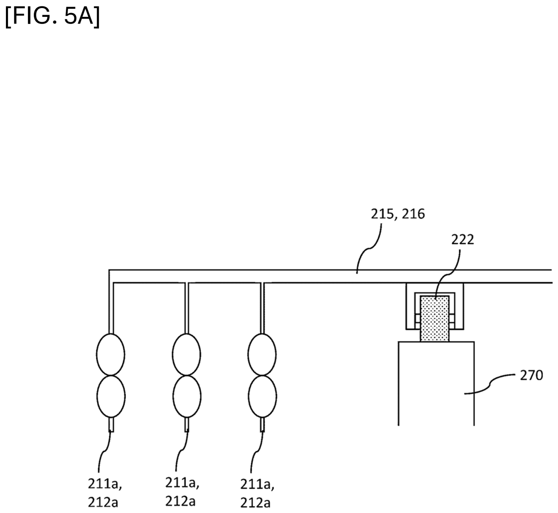

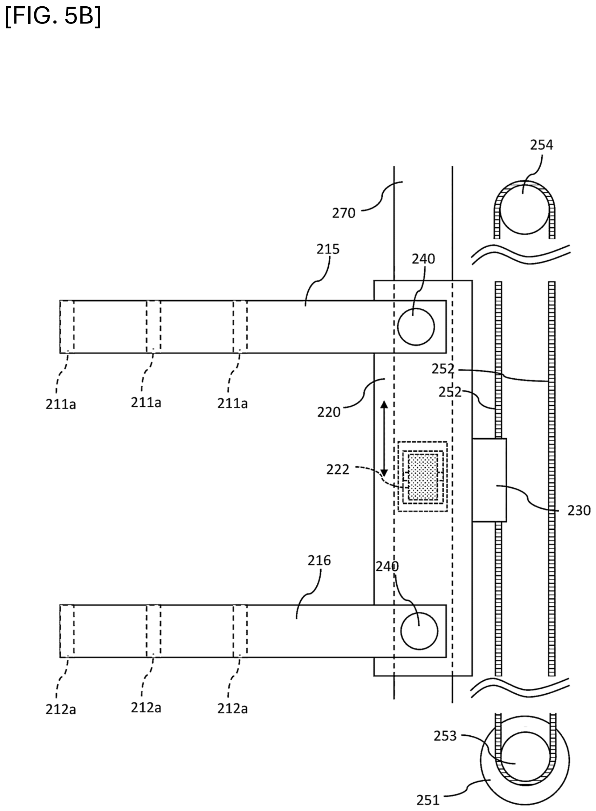

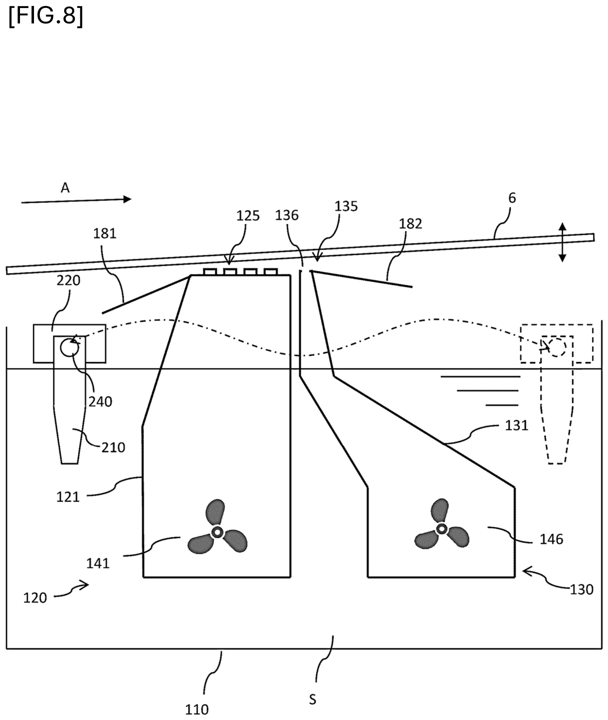

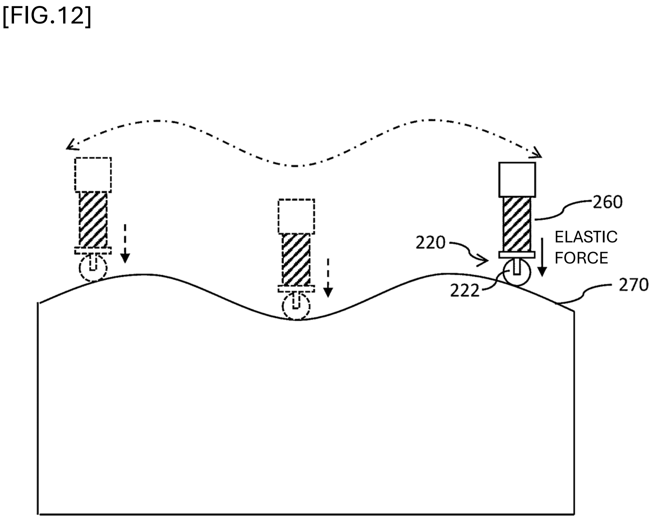

In the case of employing an aspect in which the extension part 210 reciprocates in the horizontal direction while changing the position in the vertical direction, a wave-shaped guide part 270 (see Fig. 12) for guiding the moving main body 220 may be provided. The "wave shape" in the present embodiment means that at least one of recess parts (valley parts) or protrusion parts (peak parts) which changes continuously is present. For example, in the aspect illustrated in Fig. 2, the wavy shape has one protrusion part, and in the aspect illustrated in Fig. 8, for example, the wavy shape has two protrusion parts and one recess part between the protrusion parts. The number of protrusion parts and recess parts is not particularly limited and can be changed, as appropriate. For example, an aspect can also be employed in which eight protrusion parts (peak parts) and nine recess parts (valley parts) are provided. In a case where the wave-shaped guide part 270 is employed, the position of the extension part 210 in the vertical direction is changed simply by the movement of the moving main body 220 in the horizontal direction. Hence, the position of the extension part 210 in the vertical direction can be changed with a simple configuration. For example, as illustrated in Fig. 12, a moving body 222 may move along the guide part 270, thereby moving in the horizontal direction, while the moving main body 220 changes the position in the vertical direction. The moving body 222 may be a ball bearing or a roller. Note that a mechanism movable in the vertical direction may be provided in the moving part 250, and the position in the vertical direction may be changed while the moving main body 220 is moved in the horizontal direction by the moving part 250 in response to a command from the control unit 50. In an aspect illustrated in Fig. 5B, the moving body 222 provided below the moving main body 220 moves along the guide part 270. In an aspect illustrated in Fig. 5A, the moving body 222 provided below a first coupling body 215 and a second coupling body 216 to be described below moves along the guide part 270.

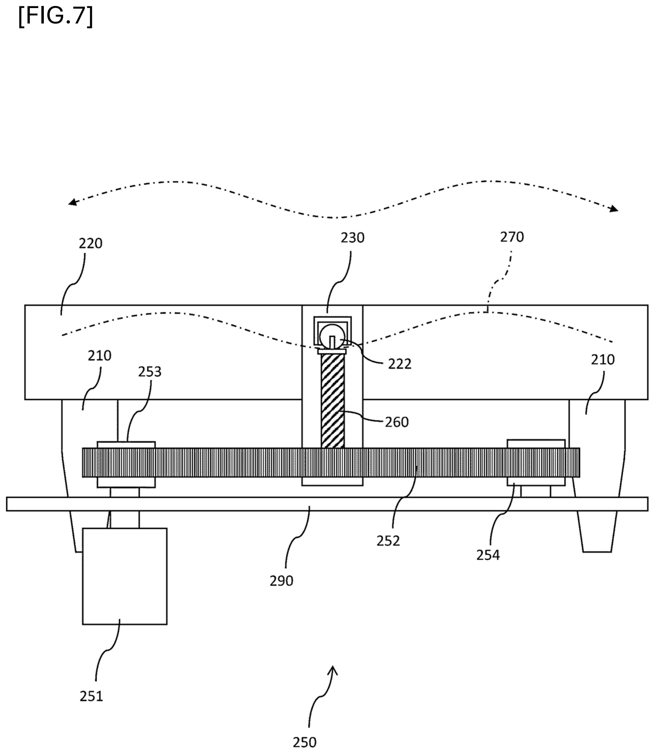

In the aspect in which the guide part 270 for guiding the moving main body 220 is provided, an elastic member 260 that applies an elastic force downward or upward to the moving main body 220 may be provided. By employing such an aspect, the moving main body 220 can be reliably moved along the guide part 270, and further, the position of the extension part 210 in the vertical direction can be reliably changed. The elastic member 260 may be made of, for example, a spring. As illustrated in Figs. 7 and 12, in a case where the guide part 270 is provided below the moving body 222, the elastic member 260 that moves together with the moving main body 220 may be provided above the moving body 222 and may press the moving body 222 downward from above (this aspect corresponds to an aspect illustrated in Fig. 12), or the elastic member 260 that moves together with the moving main body 220 may be provided below the moving body 222 and may pull the moving main body 220 downward from below (this aspect corresponds to an aspect illustrated in Fig. 7). In addition, in a case where the guide part 270 is provided above the moving body 222, the elastic member 260 that moves together with the moving main body 220 may be provided above the moving body 222 and may pull the moving main body 220 upward from above, or the elastic member 260 that moves together with the moving main body 220 may be provided below the moving body 222 and may press the moving body 222 upward from below.

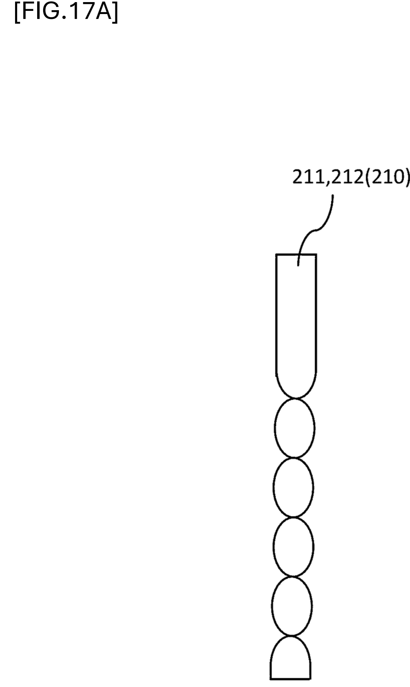

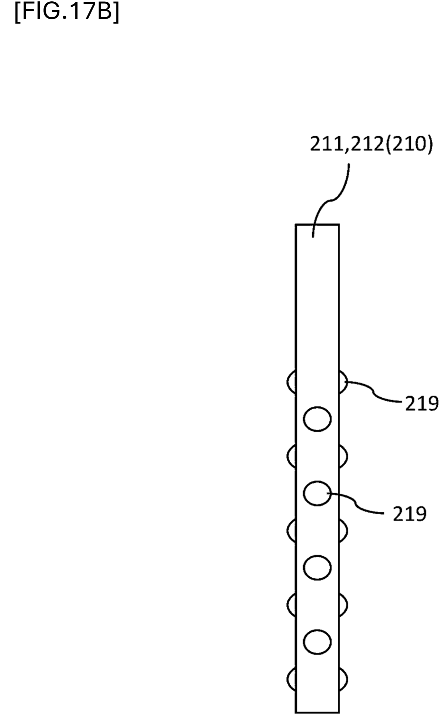

At least a part of the extension part 210 may have a non-linear shape, at least a part thereof on a distal end side immersed in the molten solder S may have a non-linear shape, and a proximal side thereof may have a linear shape. In the present application, the distal end side of the extension part 210 means the distal end side from a center position of the extension part 210 in the longitudinal direction. Since the extension part 210 has a length of about 50 mm as an example, at least a part of the extension part 210 in a range of at least 25 mm (for example, 30 mm) from a distal end thereof has a non-linear shape, in a case where the extension part 210 having a length of 50 mm is used. In addition, the length of the extension part 210 is not constant, and as another example, a non-linear shape may be formed in a range of 20 to 40 mm from the distal end of the extension part 210. Note that the entire extension part 210 may have a non-linear shape. The term "non-linear shape" in the present application includes all aspects of the aspect in which a front surface or longitudinal cross section of the extension part 210 is not linear. As confirmed by the inventors, it has been confirmed that forming of the extension part 210 in the non-linear shape as described above enables the decomposition of dross to be further accelerated and has very advantageous effects. In particular, in a case where the extension part 210 moves in the vertical direction, it is considered that the non-linear shape contributes to further acceleration of the decomposition of dross when the extension part 210 is pushed into the molten solder S. The extension part 210 having the non-linear shape may have a twisted shape, an uneven shape, or a recess part (recess parts) and/or a protrusion part (protrusion parts) 219 in the front surface of the extension part (see Fig. 17B). The twist shape may include, as an example, a twisted flat steel shape (see Figs. 5A and 17A), a screw shape in which a distal end becomes thinner, or a bolt shape. As the shape in which the recess part and/or the protrusion part are provided in the front surface, for example, the front surface may have a zigzag (jagged) shape. Note that the extension part 210 does not necessarily have a non-linear shape, and the extension part 210 may have a linear shape. In addition, the extension part 210 may extend obliquely with respect to the vertical direction.

As illustrated in Figs. 3, 4, 13, and the like, a partition part 300 that is installed in the storage tank 110 and provided between a movement region of the extension part 210 and the supply units 120 and 130 may be provided. The movement region of the extension part 210 means a range in which the extension part 210 moves in plan view. Therefore, in a case where the partition part 300 is provided, at least a part of the partition part 300 is provided between the supply units 120 and 130 and the range in which the extension part 210 moves in plan view (when viewed from above). By providing the partition part 300, the dross having accumulated in the molten solder S can be prevented from flowing toward the supply unit 120 or 130, the extension part 210 can efficiently decompose the dross present to some extent. In addition, when the dross moves toward the supply unit 120 or 130, there is a possibility that the dross may circulate together with the molten solder S and adhere to the substrate 200 being processed. However, by providing the partition part 300, such a problem can be prevented from arising.

The partition part 300 may be detachably installed in the storage tank 110. In the case of employing such an aspect, after the dross is moved on the molten solder S by a spatula or the like at a stage when the dross is generated to some extent, the dross can be separated from the supply units 120 and 130 by the partition part 300, and the dross can be prevented from flowing toward the supply unit 120 or 130. Therefore, a simple operation enables the dross to be prevented from moving toward the supply unit 120 or 130. In addition, since the movement of the dross toward the supply unit 120 or 130 is blocked by the partition part 300, effects of the decomposition by the extension part 210 reciprocating in the horizontal direction can be enhanced. As described above, in the case of employing the aspect in which the extension part 210 reciprocates in the horizontal direction in the molten solder S while changing the position in the vertical direction and also employing the partition part 300, the effects of decomposition of the dross are further enhanced, and a very advantageous result is obtained.

The partition part 300 may have a partition main body 310 extending between the supply units 120 and 130 and the extension part 210 in a moving direction (vertical direction in Figs. 3 and 4) of the extension part 210, and a pair of side partition parts 320 provided at both end parts of the partition main body 310 and extending in a direction (horizontal direction in Figs. 3 and 4) orthogonal to the moving direction of the extension part 210. The term "extending in the moving direction of the extension part 210" includes an aspect of extending obliquely with respect to the "moving direction of the extension part 210" without extending in a direction parallel to the "moving direction of the extension part 210". The pair of side partition parts 320 may be disposed to be parallel to a wall surface of the storage tank 110.

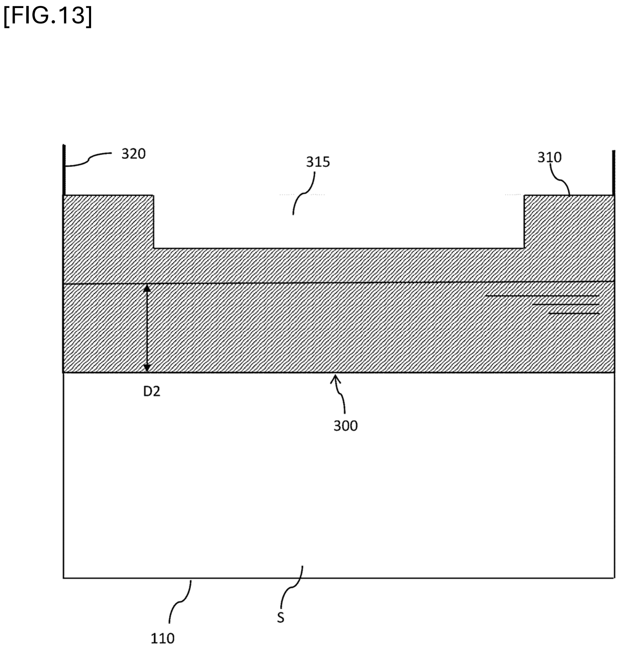

A lower end of the partition main body 310 may be positioned 20 to 80 mm below a liquid surface of the molten solder S (see D2 in Fig. 13) (in general, a liquid surface of the molten solder S reaches at a position 5 to 10 mm from an upper end of the storage tank 110). By providing the lower end at such a position, it can be expected that dross that has moved into the molten solder S naturally reaches a side of the partition part 300 opposite to the supply units 120 and 130 side (an inner side of the partition part 300). Therefore, the dross can be naturally guided to the inner side of the partition part 300, and the decomposition of the dross can be performed while the substrate 200 is processed by the supply unit 120 or 130. Therefore, it is advantageous in that the dross can be decomposed while the substrate 200 is processed without stopping the processing performed on the substrate 200 or without additional operation in a time zone in which the processing on the substrate 200 is not performed. Since it is efficient to perform decomposition processing of the dross after a certain amount of dross accumulates, the decomposition processing of dross may be intermittently performed while the substrate 200 is processed.

When the lower end is described in terms of a positional relationship with the partition main body 310 instead of the height of the liquid surface of the molten solder S, the lower end of the partition main body 310 may be located at the same position as a lower end of the extension part 210 or at a position lower than the lower end of the extension part 210, and at a position of 10 mm to 200 mm from a bottom surface of the storage tank 110. By employing such an aspect, it can be expected that the dross that has moved into the molten solder S naturally reaches the side of the partition part 300 opposite to the supply units 120 and 130 side (the inner side of the partition part 300), and the dross that has reached the partition part once is prevented from returning to a side of the partition part 300 on the supply units 120 and 130 side. More specifically, by locating the lower end of the partition main body 310 at a position of 10 mm to 200 mm from the bottom surface of the storage tank 110, it is possible to allow the dross that has moved into the molten solder S to naturally reach the side of the partition part 300 opposite to the supply units 120 and 130 side (the inner side of the partition part 300), and by locating the lower end of the partition main body 310 at the same position as the lower end of the extension part 210 or below the lower end of the extension part 210, it is possible to prevent the dross that has moved thereinto once from returning to the side of the partition part 300 on the supply units 120 and 130 side. Note that, in the case of employing an aspect in which the extension part 210 changes the position in the vertical direction and moves in the horizontal direction, the lower end of the partition main body 310 only needs to be compared with a center position in the vertical direction at which the extension part 210 is located, and when the extension part 210 is located at the center position in the vertical direction, it is advantageous to locate the lower end of the partition main body 310 at the same position as the lower end of the extension part 210 or at a position lower than the lower end of the extension part 210, that is, at a position of 10 mm to 200 mm from the bottom surface of the storage tank 110.

As illustrated in Fig. 13, a recess part 315 may be provided in a region including a central portion of the partition main body 310. By employing such an aspect, the molten solder S supplied by jetting from the supply units 120 and 130 can be easily observed visually, and a relative height position of the substrate 200 can be easily adjusted. In particular, in the case of employing the aspect in which the dross is decomposed while the substrate 200 is processed, there is a high need to enable the molten solder S supplied by jetting from the supply units 120 and 130 to be visually observed. The recess part 315 may have a length of 50% or more, 70% or more, or 80% or more of the entire length of the partition main body 310. An upper limit thereof may be 100% or 90%.

A height of the side partition part 320 may be higher than a height of the partition main body 310. The generated dross is swept in the moving direction of the extension part 210 by the movement of the extension part 210. As a result, the dross tends to accumulate on a side on which the side partition parts 320 are provided, and there is a possibility that the dross may flow out of the storage tank 110 on the side. In this respect, an increase in the height of the side partition part 320 can prevent such a problem from arising. The height of the side partition part 320 may be higher than the height of the partition main body 310 by about 20 to 50 mm. However, an aspect in which the side partition parts 320 are not provided can also be employed, and in this case, the partition part 300 includes only the partition main body 310. In addition, the side partition parts 320 do not need to be paired, and the side partition part 320 may be provided only at one end of the partition main body 310.

An upper end part of the side partition part 320 may be detachable. The upper end part of the side partition part 320 may interfere with the conveyance unit 5 that is wound around outward after conveying the substrate 200 (see, for example, Fig. 1 of JP 2022-94829). When the side partition parts 320 interfere with the conveyance unit 5 as described above, the side partition parts 320 are damaged. However, since the upper end part of the side partition part 320 is detachable, it is advantageous in that the number of parts to be replaced can be reduced and costs thereof can be reduced.

A configuration may be employed in which the molten solder S flows toward a side on which the unit including the extension part 210, the moving main body 220, the coupling body 230, and the moving part 250 is provided. For example, a bank 140 projecting upward may be provided on a side of the first supply port 125 and the second supply port 135 opposite to the side where the extension part 210 is provided (see Figs. 3 and 4), and the molten solder S supplied from the first supply port 125 and the second supply port 135 may be guided to the side on which the extension part 210 is provided (the left side in Figs. 3 and 4). In addition, an upstream adjustment part 181 and the downstream adjustment part 182 may be oblique downward toward the side on which the extension part 210 is provided (the left side in Figs. 3 and 4), and the molten solder S supplied from the first supply port 125 and the second supply port 135 may be guided to the side on which the extension part 210 is provided.

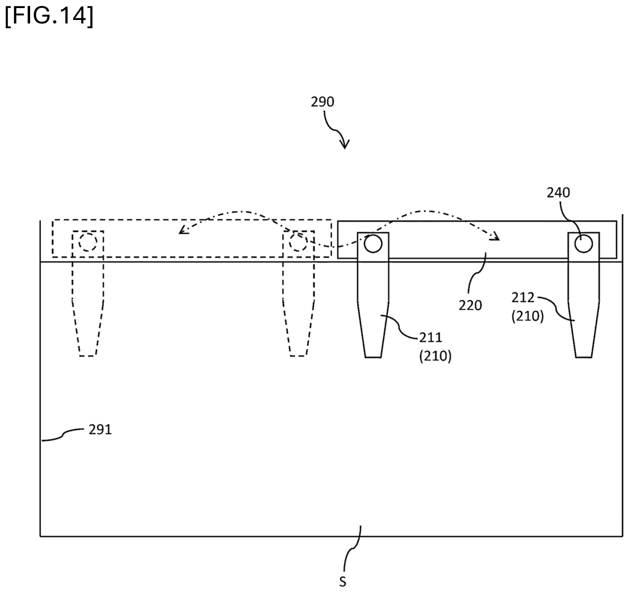

In the present embodiment, an aspect in which the extension part 210 is installed in the storage tank 110 of the jet soldering apparatus 100 is mainly described, but the present invention is not limited to such an aspect, and the extension part 210 may be installed in a separation device 290 separately provided from the jet soldering apparatus 100 (see Fig. 14). In this case, the separation device 290 corresponds to a solder process apparatus. In the case of employing the separation device 290, the molten solder S in which dross has formed is transferred to the separation device 290, and the molten solder S in which dross has formed is separated by the separation device 290. In Fig. 14, a storage tank of the separation device 290 is denoted by reference numeral 291.

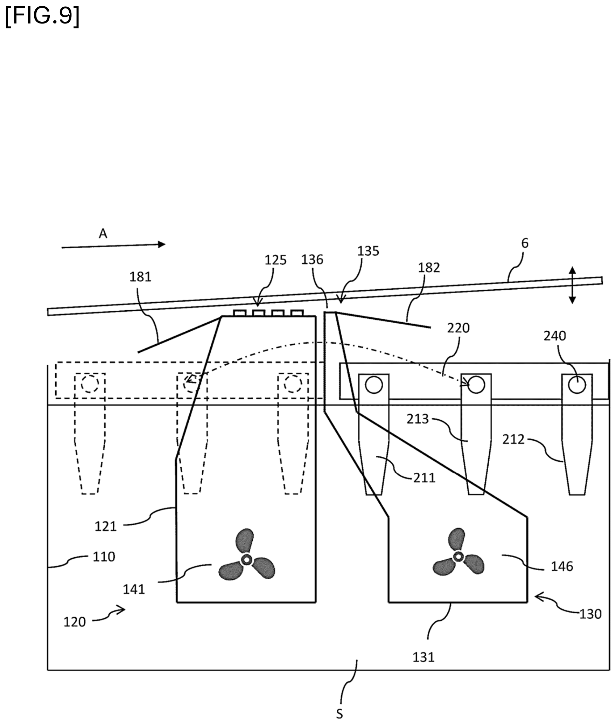

The extension part 210 may have a first extension part 211 provided on one side in the horizontal direction (for example, a side upstream in a conveyance direction A of the substrate 200: the left side in Fig. 2) and a second extension part 212 provided on the other side in the horizontal direction (for example, a side downstream in the conveyance direction A of the substrate 200: the right side in Fig. 2). The first extension part 211 may be provided at an end part of the moving main body 220 on one side, and the second extension part 212 may be provided at an end part of the moving main body 220 on the other side. The end part of the moving main body 220 on the one side means a region in a range of 20% of the moving main body 220 from the end part thereof on the one side and a region in a range of 0.2L of the moving main body 220 from the end part thereof on the one side in a case where the entire length of the moving main body 220 is represented by L. Similarly, the end part of the moving main body 220 on the other side means a region in a range of 20% of the moving main body 220 from the end part thereof on the other side, and means a range of 0.2 L from the end part thereof on the other side. In a case where the first extension part 211 and the second extension part 212 are provided as described above, the moving part 250 causes the first extension part 211 and the second extension part 212 to reciprocate in the horizontal direction in the molten solder S. The present invention is not limited to such an aspect, and a third extension part 213 provided between the first extension part 211 and the second extension part 212 may be provided (see Fig. 9), or the extension part 210 may be provided only at one location of the moving main body 220 in the horizontal direction (see Fig. 8).

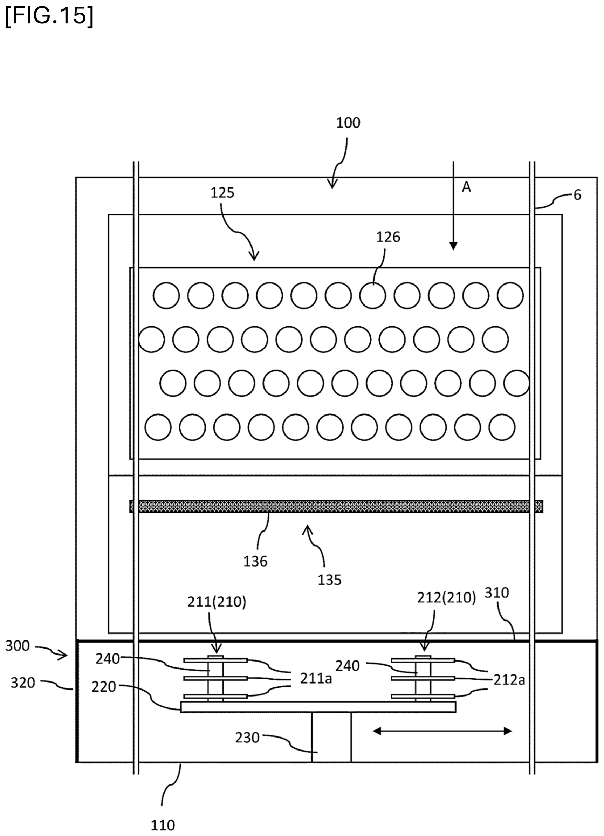

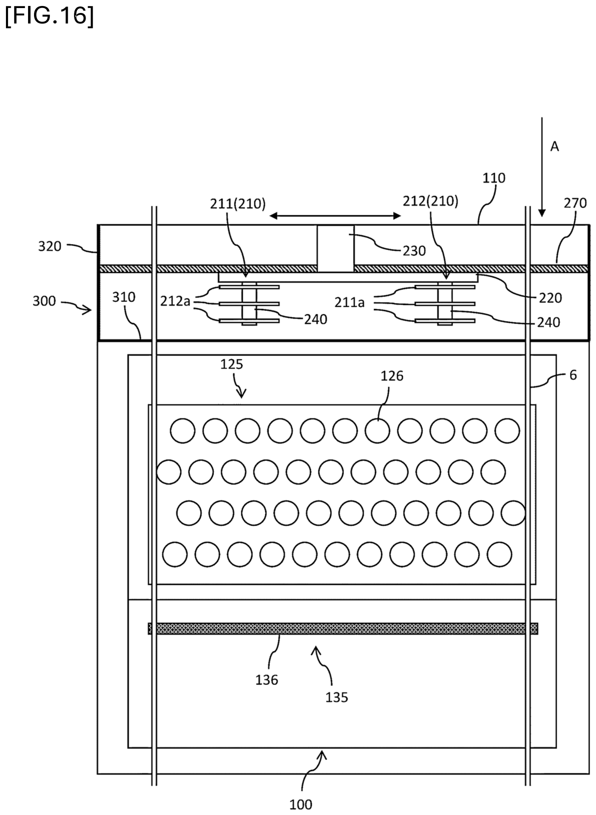

The locations where the extension parts 210 are provided are not limited to such an aspect, and the moving main bodies 220 may be provided at four or more locations of the moving main body 220 in the horizontal direction. In the present embodiment, an aspect is described in which the extension part 210 reciprocates in the horizontal direction along the conveyance direction A of the substrate 200, but the present invention is not limited to such an aspect, and for example, an aspect may be employed in which the extension part 210 reciprocates in the horizontal direction along a direction orthogonal to the conveyance direction A of the substrate 200 (see Figs. 15 and 16). However, in this case, since the extension part 210 is provided on a side below the substrate 200, there is a possibility that the extension part 210 may be brought into contact with the substrate 200. From this viewpoint, it is preferable to employ an aspect in which the extension part 210 reciprocates in the horizontal direction at a location which does not overlap a conveyance region of the substrate 200 in plan view.

As illustrated in Fig. 7, the moving part 250 may include a drive motor 251 and a drive belt 252 which is moved in the horizontal direction by the drive motor 251. The drive motor 251 has a drive gear 253, and the drive gear 253 is coupled to a driven-side drive gear 254 via the drive belt 252 (see also Fig. 5B). The coupling body 230 extending in the vertical direction is coupled to the drive belt 252, and the coupling body 230 is fixed to the moving main body 220 via a fastening member such as a screw. The drive motor 251 rotates, thereby rotating the drive belt 252, and as a result, the coupling body 230 is moved in the horizontal direction such that the moving main body 220 coupled to the coupling body 230 is moved in the horizontal direction. Note that another aspect can be employed as the moving part 250, and for example, an aspect (for example, a hydraulic cylinder) can be employed in which the coupling body 230 is moved in the horizontal direction by a cylinder can also be used (see Figs. 3 and 4). In the aspect illustrated in Figs. 3 and 4, the moving part 250 including the hydraulic cylinder extends and retracts the cylinder, so that the coupling body 230 is moved in the horizontal direction. In addition, an actuator or a single-axis slider robot may be used as the moving part 250. As the actuator, a rotational motion may be converted into a linear motion by transmitting a rotational force of the motor to a drive mechanism.

The horizontal movement of the extension part 210 for separating dross may be performed while soldering is performed on the substrate 200, or may be performed while soldering on the substrate 200 is not performed. The horizontal movement of the extension part 210 for separating the dross may be performed for about two to five minutes at a time or may be constantly performed. Moving the extension part 210 in the horizontal direction also leads to reduction in clumping of dross. In a case where the separation of dross is desired to be accelerated, a reciprocation speed in the horizontal direction may be increased. The moving speed is, for example, 2 to 20 m/min, and preferably, a lower limit value is 4 m/min and an upper limit value is 15 m/min. The dross which does not form into a clump but is separated may be manually removed by an operator or may be automatically collected by providing a screw and an accumulation box as described in JP 2002-80950 A.

The first extension part 211 may include a plurality of first extension members 211a. The first extension member 211a may be provided parallel to a normal direction of the moving direction of the coupling body 230 (see Figs. 3 and 4). The second extension part 212 may also include a plurality of second extension members 212a. The second extension members 212a may be provided parallel to the normal direction of the moving direction, and intervals between the extension members 211a and between the extension members 212a may be substantially equal to each other. In the present application, "the intervals are substantially equal to each other" means that an interval falls within 10% with respect to a largest interval A, and means that intervals between the extension members 211a and between the extension members 212a are 0.9 A or more and 1.1 A or less. The intervals between the extension members 211a and between the extension members 212a are, for example, about 10 to 30 mm. However, in a case where distal end sides of the extension members 211a and 212a have a non-linear shape, the intervals between the extension members 211a and between the extension members 212a may be set to be wide as compared with an aspect in which the entire extension member 211a or 212a has a linear shape. Although three extension members 211a and 212a are illustrated in Figs. 3 and 4, the present invention is not limited to such an aspect, and two or four or more extension members 211a and 212a may be provided. Each of the extension members 211a and 212a may have a blade, a spatula, a scoop, or the like, and a thickness thereof may be about 0.1 to 0.3 mm. Note that the intervals between the extension members 211a and between the extension members 212a may be reduced when a speed of the reciprocation is low, and the intervals between the extension members 211a and between the extension members 212a may be increased when the speed of reciprocation is high. The same member and shape may be employed for the first extension members 211a and the second extension members 212a, or different members and shapes may be employed. Note that, in a case where only one extension member is provided, the extension member and the extension part 210 have the same meaning. Therefore, in a case where only one first extension member 211a is provided, the first extension member 211a and the first extension part 211 mean the same member, and similarly, in a case where only one second extension member 212a is provided, the second extension member 212a and the second extension part 212 mean the same member.

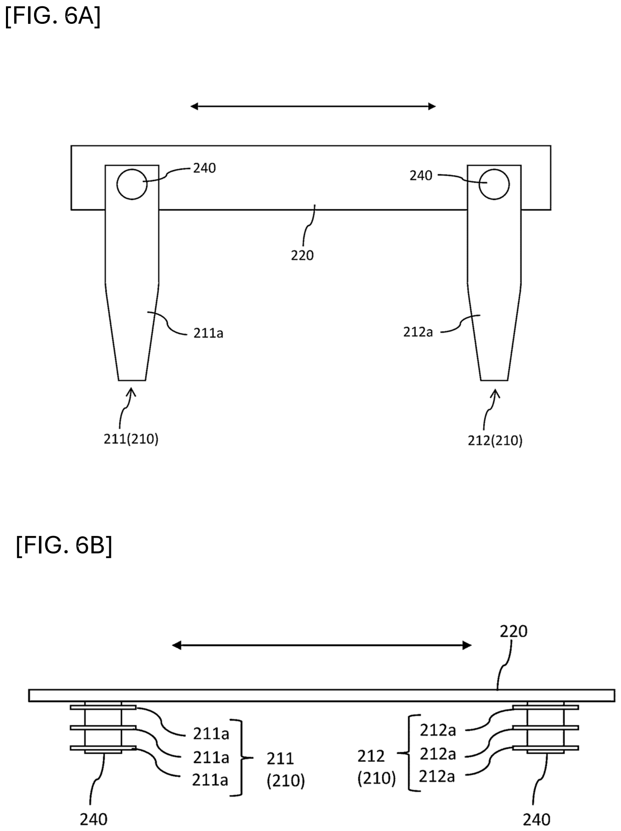

Each of the first extension members 211a and the second extension members 212a may be coupled to the moving main body 220 via a fastening member 240 such as a screw (see Figs. 2, 4, 6A, and 6B). In addition, each of the first extension members 211a may be integrated with the first coupling body 215 extending in the horizontal direction, and the first coupling body 215 may be coupled to the moving main body 220 via a fastening member 240 such as a screw (see Figs. 5A, 5B, and 3). Similarly, each of the second extension members 212a may be integrated with the second coupling body 216 extending in the horizontal direction, and the second coupling body 216 may be coupled to the moving main body 220 via a fastening member 240 such as a screw. In Fig. 5A, the first extension members 211a and the first coupling body 215, and the second extension members 212a and the second coupling body 216 are collectively illustrated, but Reference Numeral 215 is used in a case where reference numeral 211a is used, and Reference Numeral 216 is used when reference numeral 212a is used.

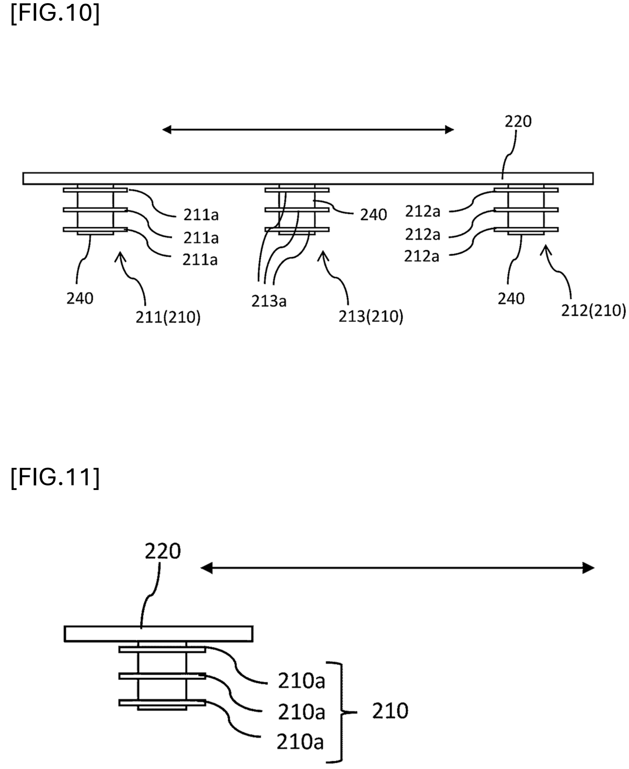

In addition, the same applies to a case where the extension part 210 is provided only at one location of the moving main body 220 or a case where the third extension part 213 is provided. In a case where the extension part 210 is provided only at one location of the moving main body 220, the extension part 210 may include a plurality of extension members 210a, the extension members 210a may be provided parallel to the normal direction to the moving direction, and the intervals between the extension members 210a may be substantially equal to each other (see Fig. 11). In a case where the third extension part 213 is provided, the third extension part 213 may include a plurality of third extension members, the third extension members may be provided parallel to the normal direction to the moving direction, and the intervals between the third extension members 213a may be substantially equal to each other (see Fig. 10). Note that, in addition to the third extension part 213, two or more extension parts 210 such as a fourth extension part and a fifth extension part may be provided between the first extension part 211 and the second extension part 212.

The moving part 250 may move the end part of the extension part 210 to a distance of 5 cm or shorter from an inner wall of the storage tank 110. In a case where the first extension part 211 and the second extension part 212 are provided, the end part (the upper end part in Figs. 3 and 4) of the first extension part 211 may be moved, and the end part (the lower end in Figs. 3 and 4) of the second extension part 212 may be moved to a distance of 5 cm or shorter from the inner wall of the storage tank 110 on the other side (see an arrow D1 in Fig. 3). By employing such an aspect, the extension part 210 can be moved to the vicinity of both end parts of the storage tank 110. In addition, the molten solder S obtained by moving the second extension part 212 in the molten solder S can be decomposed by the first extension part 211, and similarly, the molten solder S obtained by moving the first extension part 211 in the molten solder S can be decomposed by the second extension part 212. Therefore, it is possible to more effectively reduce clumping of the dross.

The extension part 210 may be immersed in the molten solder S by a length of 3 cm or longer, preferably 5 cm or longer, more preferably 10 cm or longer. In a case where the plurality of extension members 210a, 211a, 212a, and 213a are provided, each of the extension members 210a, 211a, 212a, and 213a may be immersed in the molten solder S by the length of 3 cm or longer, 5 cm or longer, or 10 cm or longer.

The extension part 210 may be made of a thermally conductive material. As an example, the extension part 210 may be made of stainless steel, steel, cast iron, a titanium alloy, a magnesium alloy, or the like. The thermal conductivity of the extension part 210 is advantageously 10 W/m·K or higher, more advantageously 13 W/m·K or higher, and still more advantageously 15 W/m·K or higher. The extension part 210 is made of a material having high thermal conductivity as described above, thereby enabling the extension part 210 to hold heat of the molten solder S. Since oxidized waste (dross) has low specific gravity, the oxidized waste floats on the upper surface of the molten solder S. However, by employing a material having the high thermal conductivity as the extension part 210, the dross can be effectively decomposed by applying heat to the dross located on the upper surface side of the molten solder S. In the case where the plurality of extension members 210a, 211a, 212a, and 213a are provided, each of the extension members 210a, 211a, 212a, and 213a may be made of a thermally conductive material.

In particular, in the case of using Sn-58Bi (Bi58Sn42) as the solder, the generation of the oxide waste was considerably increased as compared with the case of using SAC305 (Sn96.5Ag3.0Cu0.5). Therefore, the employing of the extension part 210 as in the present embodiment is particularly advantageous when Sn-58Bi is used.

Note that, in order to accelerate separation of dross, as an oxidation separator, sugars such as rice bran, barley bran, wheat bran, beans, sesame, sunflower, coconut, rapeseed, vegetable oil, and wood flour, and pine resin, ammonium chloride, amine halide, or the like may be provided in the molten solder S. As confirmed by the inventors, it was particularly advantageous to use sesame. Furthermore, it has been confirmed that, in a case where, while sesame is used, the extension part 210 is caused to reciprocate in the horizontal direction in the molten solder S while changing the position in the vertical direction, and the partition part 300 is also employed, the dross can be decomposed very quickly, and remarkably excellent effects can be obtained.

The above description of embodiment and the disclosure of the drawings are merely examples for describing the invention defined in the claims, and the invention defined in the claims is not limited by the above description of each embodiment and the disclosure of the drawings. In addition, the description of the claims at the time of filing is only an example, and the description of the claims can be changed as appropriate based on the description of the description, drawings, and the like.

### [EXPLANATION OF REFERENCE]

- 110: Storage tank
- 120, 130: Supply unit
- 210: Extension part
- 211: First extension part
- 212: Second extension part
- 219: Protrusion part
- 220: Moving main body
- 250: Moving part
- 260: Elastic member
- 270: Guide part
- 300: Partition part
- 310: Partition main body
- 315: Recess part
- 320: Side partition part
- S: Molten solder

## Claims

1. A solder process apparatus comprising:
a storage tank that stores molten solder; and
an extension part, wherein a part of the extension part is extended in the molten solder in the storage tank, and the extension part reciprocates in a horizontal direction in the molten solder while performing both upward movement and downward movement at least once when moving from one side to the other side in the horizontal direction.

2. A solder process apparatus comprising:
a storage tank that stores molten solder;
an extension part, wherein a part of the extension part is extended in the molten solder in the storage tank, and the extension part reciprocates in a horizontal direction in the molten solder while changing a position in a vertical direction;
a moving part that reciprocates the extension part in the horizontal direction in the molten solder;
a moving body that is moved in the horizontal direction by a driving force from the moving part; and
a wave-shaped guide part for guiding the moving body.

3. The solder process apparatus according to claim 2,
wherein an elastic member that applies an elastic force downward or upward to the moving body is provided.

4. A solder process apparatus comprising:
a storage tank that stores molten solder; and
an extension part, wherein a part of the extension part is extended in the molten solder in the storage tank, and the extension part reciprocates in a horizontal direction in the molten solder while changing a position in a vertical direction,
wherein at least a part of a distal end side of the extension part has a non-linear shape.

5. The solder process apparatus according to claim 4,
wherein the extension part has a twisted shape, an uneven shape, or a recess part or a protrusion part on a surface.

6. The solder process apparatus according to any one of claims 1 to 5 comprising:
a supply unit that is provided in the storage tank, and provides the molten solder, and
a partition part that is partially immersed in the molten solder, and is provided between a movement region of the extension part and the supply unit.

7. The solder process apparatus according to any one of claims 1 to 5 comprising a moving main body,
wherein the extension part has a first extension part provided on one side in the horizontal direction and a second extension part provided on the other side in the horizontal direction,
wherein the first extension part is provided at an end part of the moving main body on one side,
wherein the second extension part is provided at an end part of the moving main body on the other side,
wherein each of the first extension part and the second extension part includes a plurality of extension members, and
wherein the plurality of extension members are provided parallel along a normal direction of reciprocal movement.

8. The solder process apparatus according to any one of claims 1 to 5 comprising:
a supply unit that is provided in the storage tank, and provides the molten solder; and
a partition part that is partially immersed in the molten solder, and is provided between a movement region of the extension part and the supply unit.

9. The solder process apparatus according to claim 8,
wherein the partition part is detachably installed in the storage tank.

10. The solder process apparatus according to claim 8,
wherein the partition part has a partition main body extending in a moving direction of the extension part between the supply unit and the extension part, and a side partition part or a pair of side partition parts provided at both end parts of the partition main body and extending in a direction orthogonal to the moving direction of the extension part.

11. The solder process apparatus according to claim 10,
wherein a height of the side partition part is higher than a height of the partition main body.

12. The solder process apparatus according to claim 8,
wherein the partition part has a partition main body extending in a moving direction of the extension part between the supply unit and the extension part, and
wherein a recess part is provided in a region including a central portion of the partition main body.

13. The solder process apparatus according to claim 8,
wherein a lower end of the partition part is positioned 20 to 80 mm below a liquid surface of the molten solder.

14. The solder process apparatus according to claim 8,
wherein a lower end of the partition part is located at the same position as a lower end of the extension part or at a position lower than a lower end of the extension part, and at a position of 10 mm to 200 mm from a bottom surface of the storage tank.

15. A solder process apparatus comprising:
a storage tank that stores molten solder;
a supply unit that is provided in the storage tank, and provides the molten solder;
an extension part, wherein a part of the extension part is extended in the molten solder in the storage tank, and the extension part reciprocates in a horizontal direction in the molten solder;
a partition part that is partially immersed in the molten solder, and is provided between a movement region of the extension part and the supply unit,
wherein the extension part reciprocates in a horizontal direction in the molten solder while changing a position in a vertical direction, and
wherein a lower end of the partition part is located at the same position as an average position of a lower end of the extension part or at a position lower than an average position of a lower end of the extension part, and at a position of 10 mm to 200 mm from a bottom surface of the storage tank.
